# EUROPÄISCHE PATENTSCHRIFT

(11) **EP 1 161 127 B1**
(45) Veröffentlichungstag und Bekanntmachung des Hinweises auf die Patenterteilung: **06.06.2007**
(21) Anmeldenummer: 01108749.1
(22) Anmeldetag: 06.04.2001
(51) Int. Cl.: H05K 7/20, H05K 9/00

(54) **Elektronische Baugruppe**
Electronic module
Module électronique

(30) Priorität: 27.05.2000 DE 10026351
(43) Veröffentlichungstag der Anmeldung: 05.12.2001
(73) Patentinhaber: SIEMENS AKTIENGESELLSCHAFT, 80333 München (DE)
(72) Erfinder: Spratte, Joachim, 49090 Osnabrück (DE); Reinhardt, Jörg, 35633 Lahnau (DE); Pfifferling, Thomas, 35584 Wetzlar (DE)

(56) Entgegenhaltungen:
- DE-A- 4 226 816
- GB-A- 1 101 324
- US-A- 6 049 469
- PATENT ABSTRACTS OF JAPAN vol. 1999, no. 12, 29. Oktober 1999 (1999-10-29) -& JP 11 204970 A (ALPS ELECTRIC CO LTD), 30. Juli 1999 (1999-07-30)

## Beschreibung

Die Erfindung betrifft eine elektronische Baugruppe mit einem innerhalb einer elektromagnetischen Abschirmung angeordneten elektronischen Bauteil.

Elektronische Baugruppen der vorstehenden Art sind in den verschiedensten elektronischen Einrichtungen vorhanden, beispielsweise in Fahrzeugnavigationsgeräten oder Mobiltelefonen. Um eine ausreichende elektromagnetische Verträglichkeit zu erreichen, müssen solche Bauteile oftmals durch die elektromagnetische Abschirmung weitgehend luftdicht abgeschirmt sein, was bei verlustleistungsstarken elektronischen Bauteilen zu Problemen aufgrund der notwendigen Wärmeabfuhr führt, insbesondere dann, wenn die Abschirmung das Bauteil relativ eng umschließt.

Üblicherweise benutzt man zur Wärmeabfuhr bei elektronischen Bauteilen Kühlbleche, welche von dem Bauteil Wärme aufnehmen und über eine möglichst große Wärmeaustauschfläche an die Umgebung abgeben. Das führt bei Bauteilen mit hoher Verlustleistung jedoch zu einer unerwünscht starken Vergrößerung des erforderlichen Bauraumes.

Aus der GB-A-1 101 324 und aus der Patent Abstracts of Japan Publication No. 11204970 ist es bekannt, ein elektronisches Bauteil durch einen auf ihm aufliegenden Wärmeleitkörper mit der Abschirmung wärmeleitend zu verbinden.

Der Erfindung liegt das Problem zugrunde, eine elektronische Baugruppe der eingangs genannten Art mit einer elektromagnetischen Abschirmung so zu gestalten, dass sie möglichst kompakt ausgebildet werden kann und einfach zu montieren ist, ohne dass Probleme mit der Abfuhr der von dem Bauteil erzeugten Wärme entstehen.

Dieses Problem wird erfindungsgemäß dadurch gelöst, dass der Schirmrahmen im Bereich des Wärmeleitkörpers eine Durchbrechung hat und der Wärmeleitkörper mit einer nach unten gerichteten Nase seines gegen den Schirmrahmen anliegenden Schenkels hinter die Durchbrechung greift. Diese Ausführungsform ermöglicht eine Vormontage der Wärmeleitkörper, indem diese einfach in die jeweilige Durchbrechung eingehangen und erst später durch Schrauben fest mit dem Schirmrahmen verbunden werden.

Ganz besonders kostengünstig ist die Baugruppe herstellbar, wenn der Wärmeleitkörper ein aus der Ebene des Schirmrahmens herausgebogener und von oben her auf das Bauteil aufliegender Blechbereich des Schirmrahmens ist.

Da der Wärmeleitkörper aus einem gut wärmeleitenden Material, meist Aluminium oder Kupfer, bestehen muss, kann er nicht aufgrund seiner Elastizität mit ausreichender vorspannkraft auf das elektronische Bauteil drücken. Eine für einen guten wärmeübergang ausreichend hohe Andrückkraft ergibt sich, wenn der Wärmeleitkörper durch eine brückenartig ausgebildete Andrückfeder auf dem Bauteil gehalten ist, welche sich mit einem Bereich ihrer Basis auf dem Wärmeleitkörper abstützt und zu beiden Seiten des Bauteils jeweils ein an der Leiterplatte verankertes Federbein hat.

Die Andrückfeder ist besonders einfach gestaltet, wenn gemäß einer anderen Weiterbildung der Erfindung die beiden Federbeine jeweils durch eine Öffnung der Leiterplatte hindurchführen und auf der dem Bauteil abgewandten Seite der Leiterplatte durch jeweils einen Rastvorsprung am Federbein mit der Leiterplatte verrastet sind.

Die Erfindung lässt verschiedene Ausführungsformen zu. Zwei davon sind schematisch in der Zeichnung dargestellt und werden nachfolgend beschrieben. In ihr zeigen die
- Fig.1: einen Schnitt durch eine Baugruppe nach der Erfindung,
- Fig.2: einen im Maßstab vergrößerten und gegenüber der Figur 1 um 90° gedrehten Schnitt durch einen Teilbereich der Baugruppe,
- Fig.3: eine perspektivische Ansicht eines Eckbereiches der Baugruppe,
- Fig.4: einen Blick von der außenseite her auf einen Teilbereich eines Schirmrahmens und eines noch nicht montierten Wärmeleitkörpers,
- Fig.5: eine perspektivische Ansicht einer zweiten Ausführungsform eines Eckbereiches der Baugruppe.

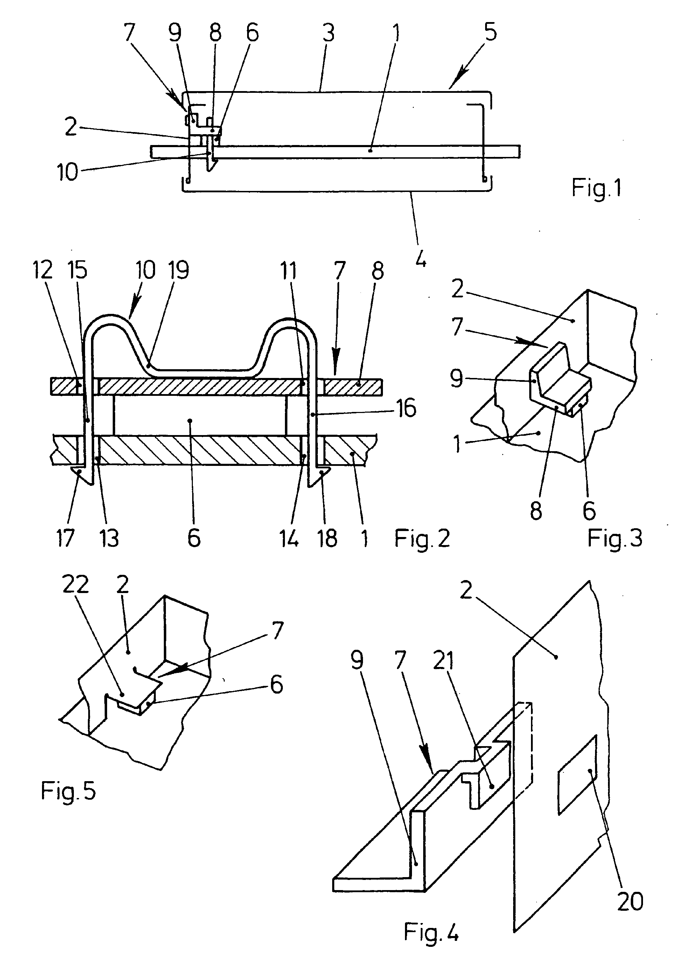

Die Figur 1 zeigt eine Leiterplatte 1, auf der ein Schirmrahmen 2 befestigt ist. Dieser Schirmrahmen 2 bildet zusammen mit zwei Schirmdeckel 3, 4 eine elektromagnetische Abschirmung 5. Innerhalb dieser elektromagnetischen Abschirmung 5 befindet sich auf der Leiterplatte 1 ein elektronisches Bauteil 6, welches eine hohe Verlustleistung hat und deshalb Wärme erzeugt. Diese Wärme wird gemäß der Erfindung über einen als Winkelblech ausgebildeten Wärmeleitkörper 7 in den Schirmrahmen 2 geleitet. Hierzu liegt der Wärmeleitkörper 7 mit einem Schenkel 8 von oben her auf dem Bauteil 6 auf und mit seinem anderen Schenkel 9 gegen den Schirmrahmen 2 an. Dadurch wird die Wärme des Bauteils 6 in den Schirmrahmen 2 geleitet, der deshalb als Wärmeaustauschfläche zu wirken vermag. Ein guter Wärmeübergang zwischen dem Bauteil 6 und dem Wärmeleitkörper 7 ergibt sich dadurch, dass eine Andrückfeder 10 den Schenkel 8 auf das Bauteil 6 drückt.

Die maßstäblich vergrößerte Schnittdarstellung gemäß Figur 2 zeigt wiederum das auf der Leiterplatte 1 sitzende Bauteil 6. Der auf dem Bauteil 6 aufliegende Schenkel 8 des Wärmeleitkörpers 7 hat zwei durchgehende Löcher 11, 12, welche zumindest in etwa mit entsprechenden Durchbrechungen 13, 14 der Leiterplatte 1 fluchten. Zu erkennen ist, dass die Andrückfeder 10 zwei Federbeine 15, 16 hat, die durch die Löcher 11, 12 und die Durchbrechungen 13, 14 hindurchführen und auf der dem Bauteil 6 abgewandten Seite der Leiterplatte 1 mittels Rastvorsprüngen 17, 18 mit dieser verrastet sind. Die beiden Federbeine 15, 16 sind oberhalb des Bauteils 6 durch eine Basis 19 miteinander verbunden, die im mittleren Bereich mit Vorspannung gegen den Schenkel 8 des Wärmeleitkörpers 7 anliegt.

Die perspektivische Ansicht gemäß Figur 3 verdeutlicht zusätzlich, wie der als Winkelblech ausgebildete Wärmeleitkörper 7 mit seinem Schenkel 9 gegen den Schirmrahmen 2 und mit seinem Schenkel 8 auf dem Bauteil 6 aufliegt.

Die Figur 4 zeigt, dass der Schirmrahmen 2 eine fensterartige Durchbrechung 20 hat. In diese Durchbrechung 20 vermag eine Nase 21 eingehangen zu werden, die im rückwärtigen Bereich des Schenkels 9 des Wärmeleitkörpers 7 nach unten ragend vorgesehen ist. Durch diese Nase 21 kann man den Wärmeleitkörper 7 zunächst lose am Schirmrahmen 2 fixieren und erst am Schluss des Montagevorganges beispielsweise mittels Schrauben endgültig befestigen.

Bei der Ausführungsform nach Figur 5 bildet der Schirmrahmen 2 zugleich den Wärmeleitkörper 7. Hierzu wurde ein Blechbereich 22 durch entsprechende Einschnitte in den Schirmrahmen 2 rechtwinklig aus der Ebene des Schirmrahmens 2 herausgebogen, so dass er von oben her vollflächig auf dem Bauteil 6 aufzuliegen vermag und dadurch in der Lage ist, Wärme vom Bauteil 6 in den Schirmrahmen 2 zu leiten.

## Patentansprüche

1. Elektronische Baugruppe mit einem innerhalb einer elektromagnetischen Abschirmung (2, 3, 4, 5), die einen Schirmrahmen (2) aufweist, angeordneten, elektronischen Bauteil (6), wobei das elektronische Bauteil (6) durch einen auf ihm aufliegenden Wärmeleitkörper (7) mit der Abschirmung (5) wärmeleitend verbunden ist, **dadurch gekennzeichnet, dass** der Schirmrahmen (2) im Bereich des Wärmeleitkörpers (7) eine Durchbrechung (20) hat und der Wärmeleitkörper (7) mit einer nach unten gerichteten Nase (21) seines gegen den Schirmrahmen (2) anliegenden Schenkels (9) hinter die Durchbrechung (20) greift.

2. Baugruppe nach Anspruch 1, bei dem die Abschirmung aus einem sich zu beiden Seiten einer Leiterplatte erstreckenden Schirmrahmen und zwei den Schirmrahmen jeweils an einer Seite verschließenden Schirmdeckeln gebildet ist, **dadurch gekennzeichnet, dass** der Wärmeleitkörper (7) mit dem Schirmrahmen (2) wärmeleitend verbunden ist.

3. Baugruppe nach den Ansprüchen 1 oder 2, **dadurch gekennzeichnet, dass** der Wärmeleitkörper (7) ein Winkelblech ist, welches mit einem Schenkel (9) an dem Schirmrahmen (2) befestigt ist und mit seinem anderen Schenkel (8) auf dem Bauteil (6) auflegt.

4. Baugruppe nach Anspruch 2, **dadurch gekennzeichnet, dass** der Wärmeleitkörper (7) durch eine brückenartig ausgebildete Andrückfeder (10) auf dem Bauteil (6) gehalten ist, welche sich mit einem Bereich ihrer Basis (19) auf dem Wärmeleitkörper (7) abstützt und zu beiden Seiten des Bauteils (6) jeweils ein an der Leiterplatte (1) verankertes Federbein (15, 16) hat.

5. Baugruppe nach Anspruch 4, **dadurch gekennzeichnet, dass** die beiden Federbeine (15, 16) jeweils durch eine Durchbrechung (13, 14) der Leiterplatte (1) hindurchführen und auf der dem Bauteil (6) abgewandten Seite der Leiterplatte (1) durch jeweils einen Rastvorsprung (17, 18) am Federbein (15, 16) mit der Leiterplatte (1) verrastet sind.

## Claims

1. Electronic module having an electronic component (6) which is arranged within an electromagnetic shielding (2, 3, 4, 5), having a shield frame (2), wherein the electronic component (6) is connected in a thermally conductive fashion to the shielding (5) by means of a thermally conductive element (7) which rests on it, **characterized in that** the shield frame (2) has an opening (20) in the vicinity of the thermally conductive element (7), and the thermally conductive element (7) engages behind the opening (20) with a downwardly directed projection (21) of its limb (9) which bears against the shield frame (2).

2. Module according to claim 1, in which the shielding is formed from a shield frame which extends on both sides of a printed circuit board and two shield covers which each close off the shield frame on one side, wherein the thermally conductive element (7) is connected in a thermally conductive fashion to the shield frame (2).

3. Module according to claim 1 or 2, wherein the thermally conductive element (7) is a bent piece of sheet metal which is attached by one limb (9) to the shield frame (2) and rests with its other limb (8) on the component (6).

4. Module according to claim 2, **characterized in that** the thermally conductive element (7) is held on the component (6) by means of a contact spring (10) which is of bridge-like design and which is supported by a region of its base (19) on the thermally conductive element (7) and has, on each side of the component (6), a spring leg (15, 16) which is anchored to the printed circuit board (1).

5. Module according to claim 4, wherein the two spring legs (15, 16) each lead through an opening (13, 14) in the printed circuit board (1) and are locked to the printed circuit board (1) on the side of the printed circuit board (1) facing away from the component (6) by means of, in each case, one locking projection (17, 18) on the spring leg (15, 16).

## Revendications

1. Module électronique comportant un composant électronique (6) placé à l'intérieur d'un blindage électromagnétique (2, 3, 4, 5), qui comporte un cadre de blindage (2), le composant électronique (6) étant lié en thermoconduction au blindage (5) par l'intermédiaire d'un corps thermoconducteur (7) qui s'applique sur le composant, **caractérisé par le fait que** le cadre de blindage (2) a une ouverture (20) dans la zone du corps thermoconducteur (7) et que le corps thermoconducteur (7) s'engage, par un talon (21) orienté vers le bas de sa branche (9) appliquée contre le cadre de blindage (2), derrière l'ouverture (20).

2. Module selon la revendication 1, dans lequel le blindage est formé par un cadre de blindage s'étendant des deux côtés d'une carte à circuits imprimés et par deux couvercles de blindage fermant chacun le cadre de blindage sur un côté, **caractérisé par le fait que** le corps thermoconducteur (7) est lié en conduction thermique au cadre de blindage (2).

3. Module selon les revendications 1 ou 2, **caractérisé par le fait que** le corps thermoconducteur (7) est une tôle coudée qui est fixée, par une branche (9), au cadre de blindage (2) et qui s'applique, par son autre branche (8), sur le composant (6).

4. Module selon la revendication 2, **caractérisé par le fait que** le corps thermoconducteur (7) est maintenu sur le composant (6) par un ressort de pression (10) conçu à la manière d'un portique, qui appuie par une partie de sa base (19) sur le corps thermoconducteur (7) et a, sur chacun des deux côtés du composant (6), une patte de ressort (15, 16) ancrée sur la carte à circuits imprimés (1).

5. Module selon la revendication 4, **caractérisé par le fait que** les deux pattes de ressort (15, 16) passent chacune à travers une ouverture (13, 14) de la carte à circuits imprimés (1) et sont, sur la face de la carte à circuits imprimés (1) opposée au composant (6), agrafées à la carte à circuits imprimés (1) chacune par une saillie à crochet (17, 18) sur la patte de ressort (15, 16).
